(19) Europäisches Patentamt
European Patent Office
Office européen des brevets

(11) **EP 4 513 895 A2**

(12) **EUROPEAN PATENT APPLICATION**

(43) Date of publication:
**26.02.2025 Bulletin 2025/09**

(21) Application number: **24196206.7**

(22) Date of filing: **23.08.2024**

(51) International Patent Classification (IPC):
**H04R 3/04** $^{(2006.01)}$  **H03G 9/00** $^{(2006.01)}$
**H03G 9/02** $^{(2006.01)}$  **H03G 5/00** $^{(2006.01)}$

(52) Cooperative Patent Classification (CPC):
**H03G 5/005; H03G 9/005; H04R 3/04;**
G10H 2210/335; H03G 9/025

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **24.08.2023 FI 20237145**

(71) Applicant: **Oeksound Oy**
**00101 Helsinki (FI)**

(72) Inventors:
• **Gröhn, Tommi**
**00740 Helsinki (FI)**
• **Keskinen, Olli**
**00250 Helsinki (FI)**

(74) Representative: **Levlin, Jan Markus**
**Aavasaksantie 13**
**00560 Helsinki (FI)**

(54) **SIGNAL PROCESSING METHOD**

(57) The invention is related to signal processing methods for processing audio signals. Especially the invention concerns signal processing methods for adjusting the tone of music signals. The invention provides a signal processing method that provides an adaptive tonality control. In the method a shape dependent filter magnitude response is calculated, a level dependent filter magnitude response is calculated, a result response is calculated based on the shape and level dependent filter magnitude responses, and an output signal is calculated by convolving an input signal with the result response. In particular, the calculation of the shape dependent filter magnitude response comprises at least the steps of

- calculating (110) a magnitude spectrum of a signal,

- filtering (120) the resulting magnitude spectrum using a first smoothing filter,

- applying (130) a predetermined weighting curve to the spectrum,

- detrending (140) said weighted spectrum by fitting a curve to said weighted spectrum and subtracting said fitted curve from said weighted spectrum, and

- inverting (150) the resulting spectrum to form the shape dependent filter magnitude response.

Fig. 1

EP 4 513 895 A2

**Description**

1. Field of the invention

The invention is related to signal processing methods for processing audio signals. Especially the invention concerns signal processing methods for adjusting the tone of music signals.

2. Description of prior art

Adjusting the tone of a music signal in high quality productions is a demanding task that requires professional sound engineers. Tone adjustments are typically needed to make the signal sound pleasant. Balance of the overtone series partials is one of the important aspects that define the timbre and tone of the sound. Several psychoacoustic metrics have been shown to correlate with specific relationships between the levels of the partials. Many musical instruments and the sung vocals produce an overtone series. Shape of the overtone series, i.e. their relative levels, can be adjusted to achieve a more balanced and pleasing sound.

In addition to tone adjustments, also the dynamic range is typically controlled. Both of these adjustments require manual effort and control.

In a prior art arrangement the processing requires manual effort and expertise: typically a sound engineer has a given input signal and an understanding of how the signal should sound like to a listener, and the sound engineer needs to know how to adjust this particular signal to reach the desired outcome. An easier way to process sound that requires less effort for a professional sound designer is needed.

SUMMARY OF THE INVENTION

The invention is directed to the method described in the characterizing part of the independent method claim. The invention is also directed to a digital signal processing apparatus described in the characterizing part of the independent apparatus claim. The invention is also directed to a computer program product described in the independent computer program product claim.

The invention solves the problems of the prior art by providing a signal processing method for a digital signal processing device that provides an adaptive tonality control, where the user is able to specify a desired weighting curve, and the processing device calculates how to filter the incoming signal. In an embodiment of the invention this calculation is performed as follows.

In the method a shape dependent filter magnitude response is calculated, a level dependent filter magnitude response is calculated, a result response is calculated based on the shape and level dependent filter magnitude responses, and an output signal is calculated by convolving an input signal with the result response. In particular, the calculation of the shape dependent filter magnitude response comprises at least the steps of

- calculating a magnitude spectrum of a signal,

- filtering the resulting magnitude spectrum using a first smoothing filter,

- applying a predetermined weighting curve to the spectrum,

- detrending said weighted spectrum by fitting a curve to said weighted spectrum and subtracting said fitted curve from said weighted spectrum, and

- inverting the resulting spectrum to form the shape dependent filter magnitude response.

In a further embodiment of the invention the method further comprises after said step of low pass filtering the step of resampling the spectrum to reduce computational complexity.

In a further embodiment of the invention the method further comprises, after said step of inverting, the step of resampling said filter magnitude response.

In a further embodiment of the invention the method further comprises, after said step of inverting the step of applying a phase transform function to said filter magnitude response.

In a further embodiment of the invention the calculation of the level dependent filter magnitude response comprises at least the steps of

- filtering said calculated magnitude spectrum of a signal using a second smoothing filter,

- applying a second predetermined weighting curve to the spectrum, and

- forming a level dependent filter magnitude spectrum by applying a level limiting function to the smoothed spectrum.

In an embodiment of the invention the result response is calculated based on the level and shape dependent filter magnitude responses in a dynamically changing way such that the less one of the responses affects the result response at a certain point, the more the other affects the result response at that point, and vice versa.

In a further embodiment of the invention the result response is calculated in such a way that:

- the less the level dependent filter magnitude response affects the result response at a point, the more the shape dependent filter magnitude response affects the result response at that point; and
- the more the level dependent filter magnitude response affects the result at a point, the less the shape dependent filter magnitude response affects the result response at that point.

In a still further embodiment of the invention the result response is calculated in such a way that:

- the less the shape dependent filter magnitude response affects the result response at a point, the more the level dependent filter magnitude response affects the result response at that point; and
- the more the shape dependent filter magnitude response affects the response at a point, the less the level dependent filter magnitude response affects the result response at that point.

The above summary relates to only few of the many embodiments of the invention disclosed herein and is not intended to limit the scope of the invention, which is set forth in the claims herein. These and other features of the present invention will be described in more detail below in the detailed description of the invention and in conjunction with the following figures.

BRIEF DESCRIPTION OF THE DRAWINGS

Various embodiments of the invention will be described in detail below, by way of example only, with reference to the accompanying drawings, of which

Figure 1 illustrates a method according to an embodiment of the invention, and
Figure 2 illustrates an apparatus according to an embodiment of the invention.

DETAILED DESCRIPTION OF CERTAIN EMBODIMENTS

The following embodiments are exemplary. Although the specification may refer to "an", "one", or "some" embodiment(s), this does not necessarily mean that each such reference is to the same embodiment(s), or that the feature only applies to a single embodiment. Features of different embodiments may be combined to provide further embodiments.

In the following, features of the invention will be described with a simple example of a sound processing method with which various embodiments of the invention may be implemented. Only elements relevant for illustrating the embodiments are described in detail. Details that are generally known to a person skilled in the art may not be specifically described herein.

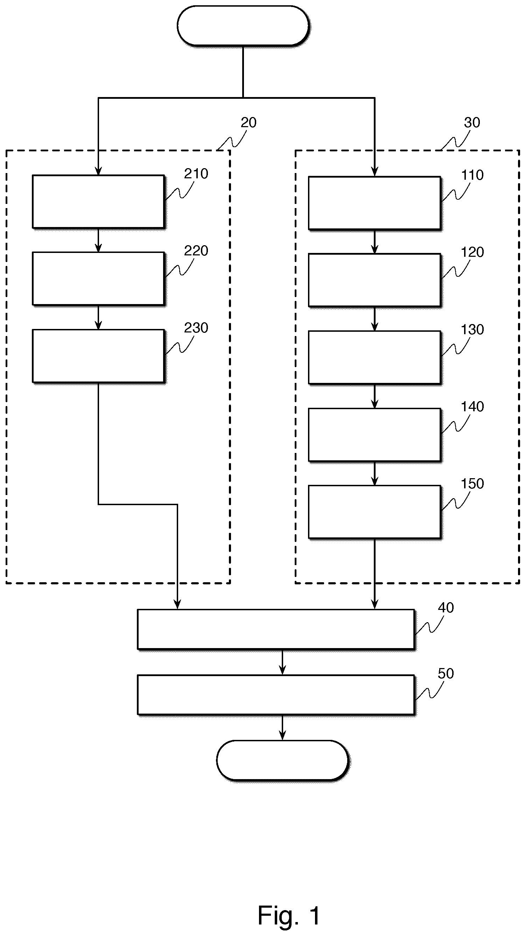

Figure 1 illustrates a signal processing method according to an embodiment of the invention. This method follows the basic structure, where a shape dependent filter magnitude response is calculated 30, a level dependent filter magnitude response is calculated 20, a result response is calculated 40 based on the shape and level dependent filter magnitude responses, and an output signal is calculated 50 by convolving an input signal with the result response. The incoming signal is processed in blocks comprising a predetermined number of signal samples. This basic structure illustrated in figure 1 is repeated to form a continuous signal analysis and processing process.

In general, in signal processing methods using this basic structure, an aim of shape dependent processing is to reduce deviation of the shape of the spectrum of the signal from a relative target spectrum, irrespective of the levels of the signal. Correspondingly, level dependent processing is generally aimed to adjust levels of the signal at various frequencies without reference to overall shape of the signal spectrum. These two types of processing are then combined to form a result filter response to process the actual signal.

According to this embodiment of the invention illustrated in figure 1, the calculation 30 of the shape dependent filter magnitude response comprises at least the steps of

- calculating 110 a magnitude spectrum of a signal,

- filtering 120 the resulting magnitude spectrum using a first smoothing filter,

- applying 130 a first predetermined weighting curve to the spectrum,

- detrending 140 said weighted spectrum by fitting a curve to said weighted spectrum and subtracting said fitted curve from said weighted spectrum, and

- inverting 150 the resulting spectrum to form the shape dependent filter magnitude response.

In step 130, applying the weighting curve to the spectrum can for example be implemented using multiplication, by multiplying the spectrum with the predetermined weighting curve. In step 120, said first smoothing filter can be for example a low pass filter.

In certain further embodiments of the invention the filtered spectrum is resampled after the filtering step 120 in order to reduce computational complexity. This resampling can be performed in a variety of ways in different embodiments of the invention. The resampling rate can be different in different implementations of the invention, and depend on the particular needs of the particular implementation.

Further, the resampling rate does not need to be constant over the spectrum. In an embodiment the resampling rate can be different at different parts of the spectrum. For example, in a further embodiment samples are added to the spectrum at low frequencies by interpolation, while samples are removed by decimation at high frequencies.

Said step of detrending 140 said weighted spectrum can be implemented in many different ways in different embodiments of the invention. For example, in an embodiment of the invention said weighted spectrum is detrended by overpass filtering, which removes a low frequency background from the spectrum while retaining details.

In a further embodiment, the detrending is performed by fitting a curve to said weighted spectrum and subtracting said fitted curve from said weighted spectrum.

The fitting of a curve to said weighted spectrum can be performed in different ways in different embodiments of the invention. For example, the fitting can be performed by weighted or non-weighted linear regression. The fitting can also be implemented using nonlinear regression, e.g. with weighted or non-weighted polynomial regression, or by using neural networks or deep learning. The fitting of a curve can in different embodiments of the invention be implemented with any fitting method known to a man skilled in the art.

In a further embodiment of the invention in which the filtered spectrum was resampled after the filtering step 120, the inverted result is resampled after the step of inverting in order to return the result to the same sample rate the filtered spectrum had before the first resampling after the filtering step 120. In other words, in order to revert the effect of the first resampling on the sampling scheme of the spectrum.

In a further embodiment of the invention the method further comprises - after said step of inverting - the step of applying a phase transform function to said filter magnitude response. Such an embodiment can use a phase transform function that reduces filter prering while retaining the approximate magnitude response. This step can be implemented for example by applying a Hilbert transform to said filter magnitude response.

While a Hilbert transform is a good choice for producing a minimum phase filter response, a man skilled in the art knows several variants of such a transform that produce a close to minimum phase filter response, i.e. a nearly minimal even if not absolutely minimum, which variants are cheaper to compute. Consequently, the invention is not limited to use of only a Hilbert transform, and various embodiments of the invention can use other phase transform functions known to a man skilled in the art.

In a further embodiment of the invention, the calculation 20 of the level dependent filter magnitude response comprises at least the steps of

- filtering 210 said calculated magnitude spectrum of a signal using a second smoothing filter,

- applying 220 a second predetermined weighting curve to the spectrum, and

- forming 230 a level dependent filter magnitude spectrum by applying a level limiting function to the smoothed spectrum.

In an embodiment of the invention said second predetermined weighting curve is at least partially different from said first predetermined weighting curve. However, in a further embodiment of the invention said first and second predetermined weighting curves are the same.

In various embodiments of the invention the level limiting function can be implemented in different ways. Said level limiting function can be implemented e.g. using frequency dependent thresholds, knee functions as well as time constants, and program dependent functions. Said level limiting function can be implemented for example as an arbitrary frequency dependent mapping function g, outputting a scaling coefficient for magnitude of each frequency, so that

$$y[f] = g(x[f], f) * x[f]$$

Instantaneous scaling coefficients may be further smoothed over time with any recursive smoothing function to avoid too abrupt changes in any of the frequency dependent scaling coefficients. A man skilled in the art knows many different ways of constructing level limiting functions, whereby such functions are not described in any further detail in this specification.

In a further embodiment of the invention the result response is calculated in such a way that the less the level dependent filter magnitude response affects the result response at a point, the more the shape dependent filter magnitude response affects the result response at that point; and the more the level dependent filter magnitude response affects the result response at a point, the less the shape dependent filter magnitude response affects the result response at that point. Such a calculation can be implemented in many different ways. Examples of such calculations are given in the following paragraphs.

In further embodiments of the invention, the method employs parameters which allow the user of a device performing the method to adjust how much and at which levels either of these responses shall dominate the result response or not. In such embodiments, the method in effect provides a dynamic choice between level and shape dependent filter magnitude responses.

In an embodiment of the invention, the result response is calculated using the following formula:

$$|H| \quad = p * A^{\wedge}(B^{\wedge}q) * B \tag{1}$$

where

IHI is the result response,
p is a predetermined constant gain compensation coefficient larger than zero,
q is a predetermined dynamic transition steepness coefficient between 0 and 1,
A is said shape-dependent filter magnitude response, and
B is said level-dependent filter magnitude response.

In this embodiment, parameter q is meant to be an user-adjustable parameter, which affects the relative strength of A and B regarding the final filtering.

Formula (1) can be expressed in a variety of ways, such as:

$$|H| = p * \exp(\log(A) * \exp(q * \log(B)) + \log(B)) \tag{2}$$

$$= p * \exp(\log(A)) \,\hat{}\, \exp(q * \log(B)) * \exp(\log(B)) \tag{3}$$

$$= p * A^{\wedge}(B^{\wedge}q) * B$$

Which of these expressions, or other expressions derived from these, is used in a particular implementation of an embodiment of the invention depends on the practical needs of such an implementation and which ways of calculation are deemed most suitable for the implementation.

In a further embodiment of the invention the blending of shape-dependent filter magnitude response A and level-dependent filter magnitude response B is performed using a linear blend for example using one of the following expressions:

$$|H| = p (B*A + (1-B)) B \tag{4}$$

$$= p (B^{\wedge}2 * A + B - B^{\wedge}2) \tag{5}$$

$$= p (B^{\wedge}2 (A - 1) + B) \tag{6}$$

These different ways to calculate the result response by combining A and B are merely examples, and the invention is not limited to using only these examples. A man skilled in the art can produce variations of these examples, whereby further variations and examples are not discussed further in this specification.

In a further embodiment of the invention said first smoothing filter is a low pass filter, said second smoothing filter is a low pass filter, and the cutoff point for said second smoothing filter is lower than the cutoff point for said first smoothing filter.

In such an embodiment, the level-dependent filter magnitude response B is in part the result of low-pass filtering with a lower cutoff point than the shape-dependent filter magnitude response A is. This has the effect that on high-level signal segments, the method optimises for time domain selectivity, and on low-level signal segments, the method optimises frequency domain selectivity. However, this particular choice of filters is merely an example, and the filters can be arranged in different ways in different embodiments of the invention.

The invention can be implemented in many different ways. The inventive method can be implemented in a dedicated signal processing device, as a part of a sound processing device such as a digital mixer unit or another apparatus, or for example with a generic computing device arranged to process digital sound signals. Further, the inventive method can be implemented as computer software stored on a computer readable medium, or for example as downloadable software made available to customers over a computer network.

The invention can also be implemented as a computer program product comprising instructions which, when the program is executed by a computing device, cause the computing device to carry out the steps of the inventive method.

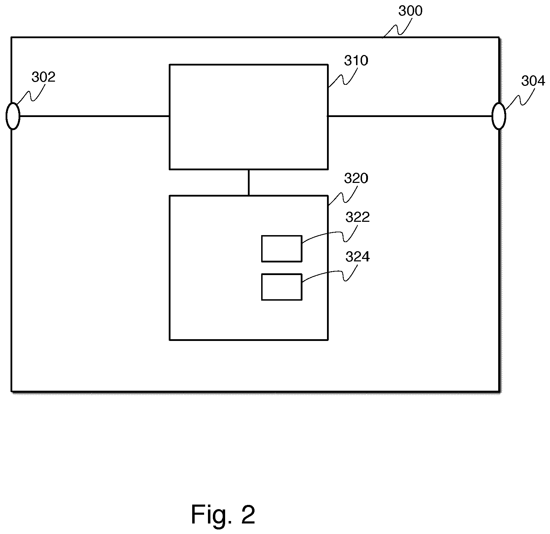

Figure 2 illustrates a digital signal processing apparatus 300. The apparatus can be for example a part of a digital mixer unit or a dedicated sound processing device, or for example a general purpose computer arranged to process sound.

The apparatus 300 comprises a processor 310 functionally connected to an input 302 and an output 304. The device comprises also a memory element 320 storing instructions 322, 324 to be executed by the processor. The instructions, when executed by the processor 310, cause the processor to perform the inventive method as described in this specification and defined in the claims.

In further embodiments of the invention the apparatus 300 can also comprise other functional elements known to a man skilled in the art such as analog-to-digital (AD) and digital-to-analog (DA) converters to enable the apparatus to input an analog signal and to output an analog signal. The device can also comprise a plurality of processors. The processors can be dedicated signal processing processors, generic programmable microprocessors or for example processors implemented using FPGAs (field programmable gate arrays).

The invention can also be implemented as a software product, as instructions stored on a storage media such that the instructions, when executed by a processor, cause the processor to perform the inventive method described in the claims. The storage media can be a semiconductor based device such as a volatile memory device, or for example a non-volatile flash memory device. Some further examples of such machine-readable storage media include RAM, ROM, read-only compact discs (CD-ROM), recordable compact discs (CD-R), rewritable compact discs (CD-RW), read-only digital versatile discs (e.g., DVD-ROM, dual-layer DVD-ROM), a variety of recordable/rewritable DVDs (e.g., DVD-RAM, DVD-RW, DVD+RW, etc.), flash memory (e.g., SD cards, mini-SD cards, micro-SD cards, etc.), magnetic and/or solid state hard drives, read-only and recordable Blu-Ray discs, ultra density optical discs, and any other optical or magnetic media.The invention can also be implemented as a downloadable software product that can be installed in a sound processing device.

Most of the method illustrated in figure 1 concerns analysis of an incoming signal, with actual processing of an incoming signal block at step 50, after the analysis steps. Whether or not the processing of a signal block at step 50 concerns the same signal block on which the analysis was performed in the previous steps varies in different embodiments of the invention. Further, in some embodiments of the invention the size of an incoming signal block used for analysis and the size of an incoming signal block used for processing can be different from each other.

In an embodiment of the invention, the incoming signal block of N samples that is processed at step 50 is the same signal block the previous analysis steps were based on. Such an embodiment has the advantage that it is computationally efficient and has very little adaptation delay. However, such an embodiment has a certain amount of latency, as an incoming block needs to be analysed before it is processed.

However, in further embodiments the processing step can use analysis results of a previous round of analysis. For example, an incoming signal block can be processed with the result response calculated from a preceding incoming signal block.

In a further embodiment of the invention, the analysis steps 20, 30, 40 are performed using incoming signal blocks of N samples, and the result responses calculated using such blocks are used to convolve incoming signal blocks of M samples. For example, in an embodiment where M is smaller than N - for example, in an embodiment N is 1024 and M is 256 - the processing latency is relatively small but adaptation delay and processing load from analysis steps is higher than in an embodiment, where the analysis is based on signal blocks of M samples.

In a further embodiment of the invention, processing and analysis is based on incoming signal blocks of N samples formed from the incoming signal sample stream at every N/M samples in such a way, that the actual processing step 50 of an incoming signal block to form an output signal block is based on the analysis of the previous incoming signal block. Since in such an embodiment consecutive signal sample blocks partially overlap a number of samples in the incoming sample stream, the main penalty of such an arrangement is a slight adaptivity delay of N/M samples.

CERTAIN BENEFITS OF THE INVENTION

The invention has a number of benefits, many of which have already been described before in this specification. Further, the invention helps in automating parts of the sound signal adjustment process, which saves time for an audio engineer. Further, the invention allows an amateur audio engineer to perform audio processing that he might not be able to do without the inventive method. The invention provides an automated method for processing both tonal control and dynamic range control in a single process, which saves work and time of an audio engineer, and allows the control of both to be done in a more optimal way.

CERTAIN FURTHER EMBODIMENTS OF THE INVENTION

In the following, we describe a number of embodiments of the invention.

According to a first aspect of the invention, a method for processing a sound signal in a digital signal processing device is provided. In the method a shape dependent filter magnitude response is calculated, a level dependent filter magnitude response is calculated, a result response is calculated based on the shape and level dependent filter magnitude responses, and an output signal is calculated by convolving an input signal with the result response. According to a first embodiment of this first aspect of the invention, calculation of the shape dependent filter magnitude response comprises at least the steps of calculating (110) a magnitude spectrum of a signal, filtering (120) the resulting magnitude spectrum using a first smoothing filter, applying (130) a first predetermined weighting curve to the spectrum, detrending (140) said weighted spectrum, and inverting (150) the resulting spectrum to form the shape dependent filter magnitude response.

According to a second embodiment of this first aspect of the invention, the method further comprises after said step of filtering the step of performing a first resampling of the magnitude spectrum to reduce computational complexity.

According to a third embodiment of this first aspect of the invention, the method further comprises after said step of inverting the step of resampling said filter magnitude response in order to revert said first resampling.

According to a fourth embodiment of this first aspect of the invention, the method further comprises after said step of inverting the step of applying a phase transform function to said filter magnitude response.

According to a fifth embodiment of this first aspect of the invention, calculating (20) of the level dependent filter magnitude response comprises at least the steps of filtering (210) said calculated magnitude spectrum of a signal using a second smoothing filter, applying (220) a second predetermined weighting curve to the spectrum, and forming (230) a level dependent filter magnitude spectrum by applying a level limiting function to the smoothed spectrum.

According to a sixth embodiment of this first aspect of the invention, the result response is calculated in such a way that the less the level dependent filter magnitude response affects the result response at a point, the more the shape dependent filter magnitude response affects the result response at that point; and the more the level dependent filter magnitude response affects the result response at a point, the less the shape dependent filter magnitude response affects the result response at that point.

According to a seventh embodiment of this first aspect of the invention, the result response is calculated by

$$|H| = p * \exp(\log(A) * \exp(q * \log(B)) + \log(B))$$
$$= p * \exp(\log(A))\,\hat{}\,\exp(q * \log(B)) * \exp(\log(B))$$
$$= p * A^{\wedge}(B^{\wedge}q) * B$$

where

> IHI is the result response,
> p is a predetermined constant gain compensation coefficient,
> q is a predetermined dynamic transition steepness coefficient,
> A is said shape-dependent filter magnitude response, and
> B is said level-dependent filter magnitude response.

According to an eighth embodiment of this first aspect of the invention, said first smoothing filter is a low pass filter, said second smoothing filter is a low pass filter, and the cutoff point for said second smoothing filter is lower than the cutoff point for said first smoothing filter.

According to a second aspect of the invention, a computer program product comprising instructions is provided which, when the program is executed by a computing device, cause the computing device to carry out the steps of the method of the first aspect of the invention.

According to a third aspect of the invention, a digital signal processing apparatus is provided. The apparatus has one or more processors (310); and one or more computer-readable storage media (320). According to a first embodiment of this third aspect of the invention the storage media has instructions (322, 324) stored thereon that, when executed by the one or more processors, cause the one or more processors to perform the steps of the method of the first aspect of the invention.

CERTAIN FURTHER OBSERVATIONS

In view of the foregoing description it will be evident to a person skilled in the art that various modifications may be made within the scope of the invention. While a preferred embodiment of the invention has been described in detail, it should be apparent that many modifications and variations thereto are possible, all of which fall within the true spirit and scope of the invention.

It is to be understood that the embodiments of the invention disclosed are not limited to the particular structures, process steps, or materials disclosed herein, but are extended to equivalents thereof as would be recognized by those ordinarily skilled in the relevant arts. It should also be understood that terminology employed herein is used for the purpose of describing particular embodiments only and is not intended to be limiting.

Reference throughout this specification to "one embodiment" or "an embodiment" means that a particular feature, structure, or characteristic described in connection with the embodiment is included in at least one embodiment of the present invention. Thus, appearances of the phrases "in one embodiment" or "in an embodiment" in various places throughout this specification are not necessarily all referring to the same embodiment.

As used herein, a plurality of items, structural elements, compositional elements, and/or materials may be presented in a common list for convenience. However, these lists should be construed as though each member of the list is individually identified as a separate and unique member. Thus, no individual member of such list should be construed as a de facto equivalent of any other member of the same list solely based on their presentation in a common group without indications to the contrary. In addition, various embodiments and example of the present invention may be referred to herein along with alternatives for the various components thereof. It is understood that such embodiments, examples, and alternatives are not to be construed as de facto equivalents of one another, but are to be considered as separate and autonomous representations of the present invention.

Furthermore, the described features, structures, or characteristics may be combined in any suitable manner in one or more embodiments. In the previous description, numerous specific details are provided, such as examples of lengths, widths, shapes, etc., to provide a thorough understanding of embodiments of the invention. One skilled in the relevant art will recognize, however, that the invention can be practiced without one or more of the specific details, or with other methods, components, materials, etc. In other instances, well-known structures, materials, or operations are not shown or described in detail to avoid obscuring aspects of the invention.

While the foregoing examples are illustrative of the principles of the present invention in one or more particular applications, it will be apparent to those of ordinary skill in the art that numerous modifications in form, usage and details of implementation can be made without the exercise of inventive faculty, and without departing from the principles and concepts of the invention. Accordingly, it is not intended that the invention be limited, except as by the claims set forth below.

**Claims**

1.  A method for processing a sound signal in a digital signal processing device, where

> a shape dependent filter magnitude response is calculated (30),
> a level dependent filter magnitude response is calculated (20),
> a result response is calculated (40) based on the shape and level dependent filter magnitude responses, and
> an output signal is calculated (50) by convolving an input signal with the result response,
> **characterised in that**
> the calculation of the shape dependent filter magnitude response comprises at least the steps of
> calculating (110) a magnitude spectrum of a signal,
> filtering (120) the resulting magnitude spectrum using a first smoothing filter,
> applying (130) a first predetermined weighting curve to the spectrum,
> detrending (140) said weighted spectrum by fitting a curve to said weighted spectrum and subtracting said fitted curve from said weighted spectrum, and
> inverting (150) the resulting spectrum to form the shape dependent filter magnitude response.

2. The method according to claim 1, **characterised in that** the method further comprises after said step of filtering the step of performing a first resampling of the magnitude spectrum to reduce computational complexity.

3. The method according to claim 2, **characterised in that** the method further comprises after said step of inverting the step of resampling said filter magnitude response in order to revert said first resampling.

4. The method according to claim 1, **characterised in that** the method further comprises after said step of inverting the step of
applying a phase transform function to said filter magnitude response.

5. The method according to claim 1, **characterised in that** calculating (20) of the level dependent filter magnitude response comprises at least the steps of

   filtering (210) said calculated magnitude spectrum of a signal using a second smoothing filter,
   applying (220) a second predetermined weighting curve to the spectrum, and
   forming (230) a level dependent filter magnitude spectrum by applying a level limiting function to the smoothed spectrum.

6. The method according to claim 1, **characterised in that**
   the result response is calculated by

$$|H| = p * \exp(\log(A) * \exp(q * \log(B)) + \log(B))$$
$$= p * \exp(\log(A)) \char`^ \exp(q * \log(B)) * \exp(\log(B))$$
$$= p * A\char`^(B\char`^q) * B$$

   where

   IHI is the result response,
   p is a predetermined constant gain compensation coefficient,
   q is a predetermined dynamic transition steepness coefficient,
   A is said shape-dependent filter magnitude response, and
   B is said level-dependent filter magnitude response.

7. The method according to claim 5, **characterised in that**

   said first smoothing filter is a low pass filter,
   said second smoothing filter is a low pass filter,
   and the cutoff point for said second smoothing filter is lower than the cutoff point for said first smoothing filter.

8. A computer program product comprising instructions which, when the program is executed by a computing device, cause the computing device to carry out the steps of the method of claim 1.

9. A digital signal processing apparatus (300),

   having one or more processors (310); and
   one or more computer-readable storage media (320),
   **characterized in that** the storage media has instructions (322, 324) stored thereon that, when executed by the one or more processors, cause the one or more processors to perform the steps of the method of claim 1.

Fig. 1

Fig. 2